# EUROPEAN PATENT APPLICATION

(11) **EP 4 697 580 A1**
(43) Date of publication of application: **18.02.2026**
(21) Application number: 25736594.0
(22) Date of filing: 23.05.2025
(51) Int. Cl.: H02M 3/28, H05K 1/02, H05K 1/18

(54) **CONTROL DEVICE**

(30) Priority: 27.06.2024 JP 2024104408
(71) Applicant: DAIKIN INDUSTRIES, LTD., Osaka-Shi, Osaka 530-0001 (JP)
(72) Inventor: FUJIWARA, Masahide, Osaka-shi, Osaka 530-0001 (JP); KOGAWA, Taiki, Osaka-shi, Osaka 530-0001 (JP); KOYAMA, Yohei, Osaka-shi, Osaka 530-0001 (JP); TAKENAKA, Kazumasa, Osaka-shi, Osaka 530-0001 (JP); KAMADA, Yuya, Osaka-shi, Osaka 530-0001 (JP); OGURI, Akihiko, Osaka-shi, Osaka 530-0001 (JP)
(74) Representative: Hoffmann Eitle
(86) International application number: PCT/JP2025/018651
(87) International publication number: WO 2026/004421

(57) **Abstract**

Provided is a control device including a printed wiring board in consideration of heat dissipation of a power supply IC. In the control device (60), a transformer (41) forms a heat dissipation space (450) with a first surface (51a) of the printed wiring board (51), and is mounted on the first surface (51a). Furthermore, the power supply IC (43) is mounted on a second surface (51b) of the printed wiring board (51) so as to face at least a part of the transformer (41). Further, the printed wiring board (51) has a plurality of vent holes (511) at locations facing the transformer (41) and at locations facing the power supply IC (43), the plurality of vent holes (511) leading to the heat dissipation space 450.

## Description

### TECHNICAL FIELD

The present invention relates to a control device equipped with a switching power supply circuit.

### BACKGROUND ART

Conventionally, the mounting area of a switching power supply circuit has been reduced for miniaturization and high density of a printed wiring board. For example, in a power converter described in Patent Literature 1 (WO2015-053142), a transformer and a power supply IC for power supply control are mounted so as to face each other with a printed wiring board interposed therebetween, thereby reducing the mounting area.

### SUMMARY OF THE INVENTION

### <Technical Problem>

However, in Patent Literature 1, since a wide space is secured around the power supply IC, heat dissipation of the power supply IC with increased temperature is not hindered. However, depending on equipment, a mounting plate for mounting a printed wiring board exists near the power supply IC, and heat dissipation of the power supply IC may be hindered. Therefore, there is a demand for a control device including a printed wiring board in consideration of heat dissipation of a power supply IC.

### <Solution to Problem>

A control device according to a first aspect includes a printed wiring board, a mounting plate, a switching transformer, and a switching power supply IC. The printed wiring board has a first surface and a second surface opposite to the first surface. The mounting plate, to which the printed wiring board is mounted, faces the second surface of the printed wiring board. The switching transformer forms a predetermined space with the first surface and is mounted on the first surface. The switching power supply IC is mounted on the second surface so as to face at least a part of the switching transformer, and controls a current input to the switching transformer. The printed wiring board has a plurality of holes at locations facing the switching transformer and at locations facing the switching power supply IC, the plurality of holes leading to the predetermined space.

In this control device, the switching transformer and the switching power supply IC face each other with the printed wiring board interposed therebetween, thereby achieving miniaturization and high density of the printed wiring board. At this time, the heat generated by the switching power supply IC raises the ambient temperature of the surrounding area, but the air with increased temperature flows through the plurality of holes into the predetermined space on the switching transformer side. As a result, the excessive temperature rise around the switching power supply IC is suppressed, and the temperature rise of the switching power supply IC is also suppressed.

A control device according to a second aspect is the control device according to the first aspect, in which the plurality of holes include a through-hole that provides electrical continuity between a predetermined first conductive pattern on the first surface and a predetermined second conductive pattern on the second surface.

In this control device, the through-hole is used not only as a hole through which air flows, but also conducts heat on the second surface side to the first surface side through the through-hole, thereby suppressing the temperature rise of the switching power supply IC.

A control device according to a third aspect is the control device according to the first or second aspect, and further includes a pedestal. The pedestal is disposed between a core of the switching transformer and the first surface of the printed wiring board so as to form the predetermined space.

In this control device, by adjusting the height dimension of the pedestal from the first surface of the printed wiring board, the predetermined space is adjusted to a space having a size suitable for diffusion of air passing through the holes from the second surface side.

A control device according to a fourth aspect is the control device according to the third aspect, in which the height of the pedestal is set such that the shortest distance from the first surface of the printed wiring board to the lowermost point of the switching transformer falls within the range of 5-10 mm, both inclusive.

A control device according to a fifth aspect is the control device according to any one of the first to fourth aspects, in which the number of the holes falls within the range of 4-14, both inclusive.

A control device according to a sixth aspect is the control device according to any one of the first to fifth aspects, in which the switching power supply IC is a rectangular package that incorporates a switching element and a control IC. The switching power supply IC has a lead terminal along a short side of the package.

In this control device, the switching power supply IC is disposed in straddling relation to the insulating region between the primary circuit and secondary circuit of the switching power supply circuit on which the switching transformer is mounted, one lead terminal of the switching power supply IC is connected to the primary circuit, and the other lead terminal of the switching power supply IC is connected to the secondary circuit. Therefore, it is advantageous that the terminal of the switching power supply IC is disposed along the short side of the package.

### BRIEF DESCRIPTION OF THE DRAWINGS

FIG. 1 is a circuit diagram of a switching power supply circuit of a control device according to an embodiment of the present disclosure.
FIG. 2 is a perspective view of the periphery of a transformer mounted on a printed wiring board of the control device.
FIG. 3 is a plan view of the portion of the printed wiring board on which a power supply IC is mounted, on a second surface on the opposite side from a first surface on which the transformer is mounted.
FIG. 4 is a partial cross-sectional side view of the printed wiring board on which the transformer and the power supply IC are mounted.

### DESCRIPTION OF EMBODIMENT

### (1) Outline of Switching Power Supply Circuit 30 of Control Device 60

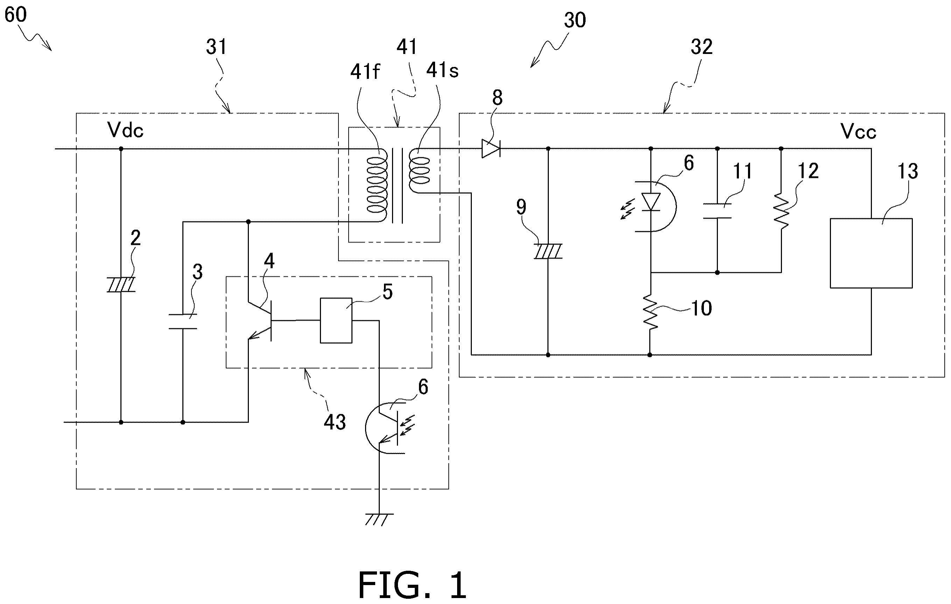

FIG. 1 is a circuit diagram of a switching power supply circuit 30 of a control device 60 according to an embodiment of the present disclosure. In FIG. 1, the control device 60 is used in, for example, an outdoor unit or indoor unit of an air conditioner. The switching power supply circuit 30 generates a control voltage for the control device 60.

A transformer 41 is a switching transformer and has a primary winding 41f and a secondary winding 41s. Here, the circuit connected to the primary winding 41f is referred to as a primary circuit 31, and the circuit connected to the secondary winding 41s is referred to as a secondary circuit 32.

### (1-1) Primary Circuit 31

A DC voltage Vdc is supplied to the primary winding 41f of the transformer 41. The DC voltage Vdc is obtained by full-wave rectifying a commercial AC voltage and smoothing the commercial AC voltage with an electrolytic capacitor 2. A switching element 4 is connected in series to the primary winding 41f. A resonance capacitor 3 is connected in parallel between the output terminals (collector and emitter) of the switching element 4.

Furthermore, a control IC 5 is connected to the base of the switching element 4, and the output circuit of a photocoupler 6 is further connected to the control IC 5. The control IC 5 performs control such that the higher the output current of the photocoupler 6, the shorter the period during which the switching element 4 is turned on, and the lower the output current of the photocoupler 6, the longer the period during which the switching element 4 is turned on. The switching element 4 and the control IC 5 constitute a packaged switching power supply IC, and will be hereinafter referred to as a power supply IC 43.

### (1-2) Secondary Circuit 32

The voltage generated in the secondary winding 41s of the transformer 41 is supplied to an electrolytic capacitor 9 via a diode 8, and is smoothed by the electrolytic capacitor 9. The smoothed output voltage is provided to an electronic device such as a microcomputer 13 as a DC voltage Vcc for control.

The output voltage is also applied to the series circuit of the input circuit of the photocoupler 6 and a resistor 10, and a current flows through the input circuit (light-emitting diode) of the photocoupler 6. At this time, the current flowing through the photocoupler 6 increases or decreases in accordance with the increase or decrease of the output voltage.

Specifically, using the predetermined value of Vcc as a reference value, when the output voltage becomes higher than the reference value, the current flowing through the input and output circuits of the photocoupler 6 increases relatively, and the control IC 5 of the power supply IC 43 operates to shorten the period during which the switching element 4 is turned on.

As a result, the output voltage decreases. Conversely, when the output voltage becomes lower than the reference value, the current flowing through the input and output circuits of the photocoupler 6 decreases relatively, and the control IC 5 of the power supply IC 43 operates to extend the period during which the switching element 4 is turned on. As a result, the output voltage increases. By such feedback operation, the output voltage is maintained at a constant voltage.

In addition, an abnormal voltage absorption capacitor 11 and a resistor 12 are connected in parallel to the input circuit of the photocoupler 6. The resistor 12 divides the output voltage together with the resistor 10, and regulates the voltage applied to the input circuit of the photocoupler 6 so that the voltage does not exceed an allowable range.

The abnormal voltage absorption capacitor 11 absorbs surge noise caused by switching and external noise. Therefore, as the abnormal voltage absorption capacitor 11, a ceramic capacitor excellent in responsiveness to a surge noise caused by switching and a highfrequency component of external noise is adopted. The external noise comes from, for example, an inverter circuit (not illustrated) controlled by the microcomputer 13.

Here, the switching power supply circuit 30 with the photocoupler 6 has been described as an example, but the present invention is not limited thereto, and the switching power supply circuit may be a switching power supply circuit equipped with a power supply IC adopting a technology that eliminates the need for a photocoupler.

### (2) Mounting State of Transformer 41 and Power Supply IC

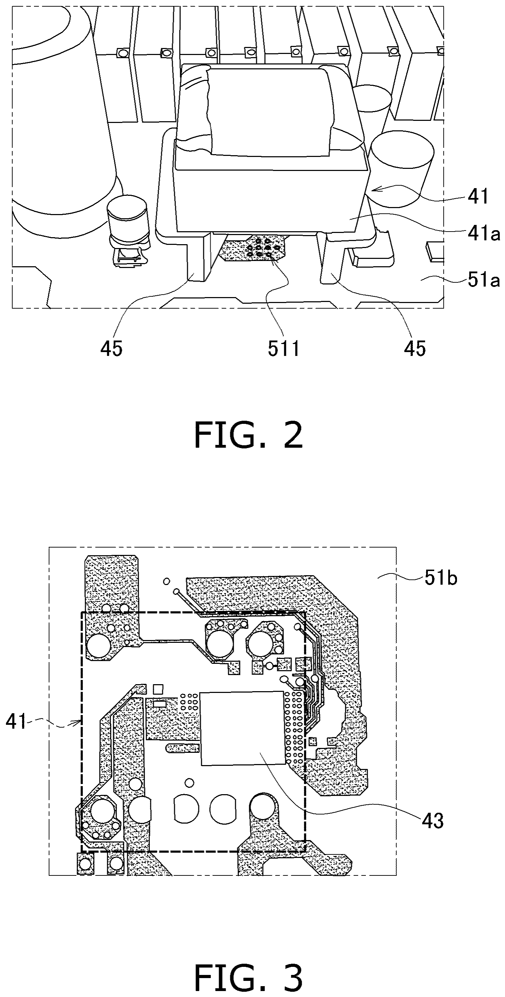

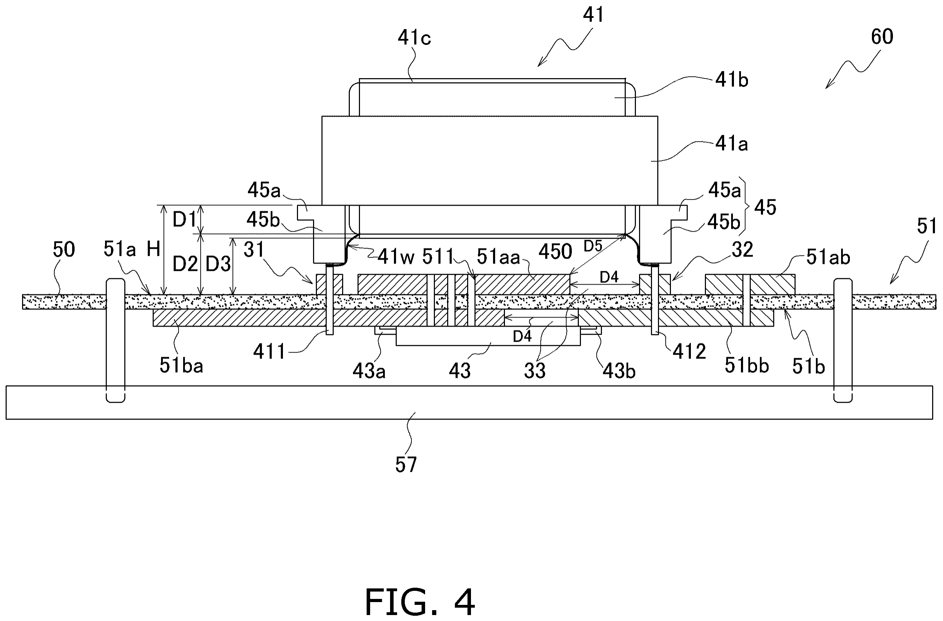

FIG. 2 is a perspective view of the periphery of the transformer 41 mounted on a printed wiring board 51 of the control device 60. In addition, FIG. 3 is a plan view of the portion of the printed wiring board 51 on which the power supply IC 43 is mounted, on a second surface 51b on the opposite side from a first surface 51a on which the transformer 41 is mounted. Further, FIG. 4 is a partial cross-sectional side view of the printed wiring board 51 on which the transformer 41 and the power supply IC 43 are mounted.

### (2-1) Printed Wiring Board 51

In FIGS. 2 to 4, the printed wiring board 51 has a base material 50 having an insulating property and a conductor layer formed on the first surface 51a on one side of the base material 50. The conductor layer forms a conductive pattern including a first-A conductive pattern 51aa and a first-B conductive pattern 51ab. The conductor layer is covered with an insulating film (not illustrated). The transformer 41 is mounted on the first surface 51a of the printed wiring board 51.

The printed wiring board 51 further has a conductor layer formed on the second surface 51b on the other side of the base material 50. The conductor layer forms a conductive pattern including a second-A conductive pattern 51ba and a second-B conductive pattern 51bb. The conductor layer is covered with an insulating film (not illustrated). The power supply IC 43 is mounted on the second surface 51b of the printed wiring board 51.

In the printed wiring board 51, the primary circuit 31 and the secondary circuit 32 illustrated in FIG. 1 are formed on the first surface 51a and the second surface 51b. An insulating region 33 is provided between the primary circuit 31 and the secondary circuit 32.

The first-A conductive pattern 51aa on the first surface 51a is connected to the second-A conductive pattern 51ba on the second surface 51b through a through-hole. Similarly, the first-B conductive pattern 51ab on the first surface 51a is connected to the second-B conductive pattern 51bb on the second surface 51b through a through-hole. The through-hole is conductive hole-shaped wiring that goes through the printed wiring board 51.

### (2-2) Mounting State of Transformer 41

On the first surface 51a, the transformer 41 is disposed in straddling relation to the insulating region 33, a primary terminal 411 is connected to the first-A conductive pattern 51aa and the second-A conductive pattern 51ba of the primary circuit 31, and a secondary terminal 412 is connected to the first-B conductive pattern 51ab and the second-B conductive pattern 51bb of the secondary circuit 32.

The transformer 41 is mounted on the first surface 51a with pedestals 45 interposed therebetween. Therefore, a space is formed between the transformer 41 and the first surface 51a by the pedestals 45.

### (2-3) Mounting State of Power Supply IC

On the second surface 51b, the power supply IC43 is disposed in straddling relation to the insulating region 33, a primary terminal 43a is connected to the second-A conductive pattern 51ba of the primary circuit 31, and a secondary terminal 43b is connected to the second-B conductive pattern 51bb of the secondary circuit 32.

A rectangular bold frame drawn by a broken line in FIG. 3 indicates the size of the projected area of the transformer 41 mounted on the first surface 51a. The power supply IC 43 is contained within the rectangular bold frame, and contributes to the miniaturization and high density of the printed wiring board 51. However, the power supply IC 43 does not need to be completely contained within the rectangular bold frame, and may only partially overlap.

### (3) Heat Dissipation Measures for Power Supply IC 43

As illustrated in FIG. 4, the printed wiring board 51 is mounted such that the second surface 51b on which the power supply IC 43 is mounted faces a mounting plate 57. Therefore, the heat generated from the power supply IC 43 is easily confined between the second surface 51b and the mounting plate 57. The mounting plate 57 is, for example, a plate-shaped member forming the outer contour of the electric component box of the air conditioner.

In general, measures are taken to improve thermal conductivity and heat dissipation by increasing the areas of the second-A conductive pattern 51ba connected to the primary terminal 43a and the second-B conductive pattern 51bb connected to the secondary terminal 43b of the power supply IC 43.

In the control device 60 according to the present embodiment, in addition to the above measures, a heat dissipation space 450 is formed between the first surface 51a of the printed wiring board 51 and the transformer 41, and furthermore, a plurality of vent holes 511 leading to the heat dissipation space 450 from the second surface 51b facing the power supply IC 43 through the printed wiring board 51 are provided. Some or all of the plurality of vent holes 511 may be through-holes.

### (3-1) Heat Dissipation Space 450

The heat dissipation space 450 is formed by the two pedestals 45. As illustrated in FIG. 4, the pedestals 45 each have a support portion 45a that receives the end of a core 41a, and a leg portion 45b that holds the support portion 45a.

In addition, the pedestals 45 hold the primary terminal 411 and secondary terminal 412 of the transformer 41, and the primary terminal 411 and the secondary terminal 412 are soldered to the printed wiring board 51, whereby the transformer 41 and the pedestals 45 are fixed to the printed wiring board 51.

The heat dissipation space 450 is a gap space between the first surface 51a and the lower end of winding 41b of the transformer 41, and is adjusted to a space having a size suitable for air diffusion by adjusting the height from the first surface 51a to the top of the pedestals 45 (height H of the pedestals 45).

### (3-2) Height Setting of Pedestal 45

The height H of the pedestals 45 is the sum of a first distance D1, which is the shortest distance between the core 41a and a lead wire 41w drawn out from insulating tape 41c of the winding 41b, and a second distance D2, which is the height required to constitute the primary terminal 411 and the secondary terminal 412.

The first distance D1 is set to satisfy a creepage distance of 4 mm or more and a spatial distance of 3 mm or more so that the insulation distance between the lead wire 41w and the core 41a is secured.

Furthermore, a third distance D3, which is the shortest distance from the first surface 51a of the printed wiring board 51 to the lowermost point of the winding 41b, is increased or decreased by adjusting the second distance D2. The third distance D3 is desirably within the range of 5-10 mm, both inclusive, in consideration of the distance between the control device 60 and the peripheral structure.

### (3-3) Vent Hole 511

As illustrated in FIGS. 2 and 4, the plurality of vent holes 511 not only penetrate the printed wiring board 51 but also lead to the heat dissipation space 450, so that heat generated by the power supply IC 43 can be guided to the heat dissipation space 450.

In the present embodiment, the vent holes 511 also penetrate the first-A conductive pattern 51aa on the first surface 51a and the second-A conductive pattern 51ba on the second surface, and all the vent holes 511 can be through-holes.

In such a case, the through-holes not only function as the vent holes 511 but also function as heat conductors that transfer heat on the second surface 51b side to the first surface 51a side. As a result, the temperature rise of the power supply IC 43 is suppressed.

The effect of suppressing the temperature rise of the power supply IC 43 appears with four vent holes 511 and becomes saturated with 14 or more vent holes 511. Therefore, the number of vent holes 511 is preferably set within the range of 4-14, both inclusive.

### (4) Insulation Distance of Insulating Region 33

In the switching power supply circuit 30, "creeping insulation distance D4" and "spatial insulation distance D5" illustrated in FIG. 4 are required to satisfy standard values as the insulation distance between the primary circuit 31 and the secondary circuit 32.

The creeping insulation distance D4 is the horizontal distance of the insulating region 33 separating the primary circuit 31 and the secondary circuit 32. The spatial insulation distance D5 is the shortest distance between the first-A conductive pattern 51aa of the primary circuit 31 and the lead wire 41w.

In the present embodiment, the creeping insulation distance D4 is set to be greater than or equal to a value (unit: mm) obtained by adding 0.3412 to a value obtained by multiplying 0.0027 by the peak value of the operating voltage.

Further, it is sufficient if the spatial insulation distance D5 is 2.5 mm or more.

### (5) Features

(5-1)
In the control device 60, the transformer 41 forms the heat dissipation space 450 with the first surface 51a of the printed wiring board 51, and is mounted on the first surface 51a. Furthermore, the power supply IC 43 is mounted on the second surface 51b of the printed wiring board 51 so as to face at least a part of the transformer 41. Further, the printed wiring board 51 has a plurality of vent holes 511 at locations facing the transformer 41 and at locations facing the power supply IC 43, the plurality of vent holes 511 leading to the heat dissipation space 450.

As described above, in the control device 60, the transformer 41 and the power supply IC 43 face each other with the printed wiring board 51 interposed therebetween, thereby achieving miniaturization and high density of the printed wiring board 51. At this time, the heat generated by the power supply IC 43 raises the ambient temperature of the surrounding area, but air flows through the vent holes 511 into the heat dissipation space 450 on the transformer 41 side, so that the excessive temperature rise around the power supply IC 43 is suppressed.

(5-2)
The plurality of vent holes 511 include a through-hole that provides electrical continuity between the first-A conductive pattern 51aa on the first surface 51a and the second-A conductive pattern 51ba on the second surface 51b.

In the control device 60, the through-hole is used as the air vent hole 511, and as a result, the temperature rise of the power supply IC 43 is suppressed. In addition, the heat on the second surface 51b side is conducted to the first surface 51a side through the through-hole, and as a result, the temperature rise of the power supply IC 43 is further suppressed.
(5-3)
   In the control device 60, the pedestal 45 is disposed between the core 41a of the transformer 41 and the first surface 51a of the printed wiring board 51, thereby forming the heat dissipation space 450. By adjusting the dimension of the height H of the pedestal 45 from the first surface 51a of the printed wiring board 51, the heat dissipation space 450 is adjusted to a space having a size suitable for diffusion of air passing through the vent holes 511 from the second surface 51b side.
(5-4)
   In control device 60, the height H of the pedestal 45 is set such that the shortest distance from the first surface 51a of the printed wiring board 51 to the lowermost point of the transformer 41 falls within a range of 5-10 mm, both inclusive.
(5-5)
   The number of the vent holes 511 falls within a range of 4-14, both inclusive.

### (6) Others

The power supply IC 43 is a rectangular package that incorporates the switching element 4 and the control IC 5. The power supply IC 43 according to the present embodiment is a package having a square shape in plan view, but is not limited thereto, and may be a package having a rectangular shape in plan view.

In the case of a rectangular package, the terminals are arranged along the short sides of the package. In such a case, the power supply IC 43 is disposed in straddling relation the insulating region 33 between the primary circuit 31 and secondary circuit 32 of the switching power supply circuit 30, and the primary terminal 43a on one side of the power supply IC 43 is connected to the primary circuit 31, and the secondary terminal 43b on the other side of the power supply IC 43 is connected to the secondary circuit 32.

Therefore, arranging the terminals of the power supply IC 43 along the short sides of the package allows the terminals to straddle a wider insulating region, which is advantageous in increasing the insulation distance.

The embodiment of the present disclosure has been described above. It will be understood that various modifications to modes and details should be available without departing from the gist and the scope of the present disclosure recited in the claims.

### REFERENCE SIGNS LIST

4: switching element
5: control IC
41: transformer (switching transformer)
41a: core
43: power supply IC (switching power supply IC)
43a: primary terminal (lead terminal)
43b: secondary terminal (lead terminal)
45: pedestal
51: printed wiring board
51a: first surface
51aa: first-A conductive pattern (first conductive pattern)
51b: second surface
51ba: second-A conductive pattern (second conductive pattern)
57: mounting plate
60: control device
450: heat dissipation space (predetermined space)
511: vent hole (hole)

### CITATION LIST

### PATENT LITERATURE

Patent Literature 1: WO 2015-053142 A

## Claims

1. A control device (60) comprising:
a printed wiring board (51) having a first surface (51a) and a second surface (51b) opposite to the first surface (51a);
a mounting plate (57) to which the printed wiring board (51) is mounted, the mounting plate (57) facing the second surface (51b) of the printed wiring board (51);
a switching transformer (41) that forms a predetermined space (450) with the first surface (51a) and is mounted on the first surface (51a); and
a switching power supply IC (43) that is mounted on the second surface (51b) so as to face at least a part of the switching transformer (41) and controls a current input to the switching transformer (41), wherein
the printed wiring board (51) has a plurality of holes (511) at locations facing the switching transformer (41) and at locations facing the switching power supply IC (43), the plurality of holes (511) leading to the predetermined space (450).

2. The control device (60) according to claim 1, wherein
the plurality of holes (511) include a through-hole that provides electrical continuity between a predetermined first conductive pattern (51aa) on the first surface (51a) and a predetermined second conductive pattern (51ba) on the second surface (51b).

3. The control device (60) according to claim 1 or 2, further comprising
a pedestal (45) disposed between a core (41a) of the switching transformer (41) and the first surface (51a) of the printed wiring board (51) so as to form the predetermined space (450).

4. The control device (60) according to claim 3, wherein
a shortest distance from the first surface (51a) of the printed wiring board (51) to a lowermost point of the switching transformer (41) falls within a range of 5-10 mm, both inclusive.

5. The control device (60) according to any one of claims 1 to 4, wherein
the number of the holes (511) falls within a range of 4-14, both inclusive.

6. The control device (60) according to any one of claims 1 to 5, wherein
the switching power supply IC (43) is a rectangular package that incorporates a switching element (4) and a control IC (5), and
the switching power supply IC (43) has a lead terminal (43a, 43b) along a short side of the package.
